Europäisches Patentamt

European Patent Office

Office européen des brevets

(19)

(11) Numéro de publication: **0 172 108
B1**

(12) **FASCICULE DE BREVET EUROPEEN**

(45) Date de publication du fascicule du brevet:
**03.05.89**

(51) Int. Cl.⁴: **H 01 L 23/56**, G 06 K 19/06

(21) Numéro de dépôt: **85401606.0**

(22) Date de dépôt: **06.08.85**

(54) **Dispositif de neutralisation de l'accès à une zone à protéger d'un circuit intégré.**

(30) Priorité: **10.08.84  FR 8412679**

(43) Date de publication de la demande:
**19.02.86 Bulletin 86/8**

(45) Mention de la délivrance du brevet:
**03.05.89 Bulletin 89/18**

(84) Etats contractants désignés:
**DE FR GB IT NL**

(56) Documents cités:
**EP-A- 0 025 347
FR-A- 2 471 051
FR-A- 2 503 424
US-A- 4 105 156**

(73) Titulaire: **SGS-THOMSON MICROELECTRONICS S.A.,
101, bld Murat, F-75016 Paris (FR)**

(72) Inventeur: **Silvestre de Ferron, Gérard, THOMSON-CSF
SCPI 173, bld Haussmann, F-75379 Paris Cedex 08 (FR)**
Inventeur: **Gaultier, Jean-Marie, THOMSON-CSF
SCPI 173, bld Haussmann, F-75379 Paris Cedex 08 (FR)**

(74) Mandataire: **Ballot, Paul Denis Jacques et al, Cabinet
Ballot-Schmit 84, avenue Kléber, F-75116 Paris (FR)**

## Description

La présente invention a pour objet un dispositif de neutralisation de l'accès à une zone à protéger d'un circuit intégré. Elle trouve particulièrement son utilisation dans le domaine des cartes à mémoire. Le domaine des cartes à mémoire couvre en partie celui des cartes de crédit et des cartes de paiement. Dans une carte à mémoire des informations relatives à l'identité du titulaire de la carte, relatives à son code secret de transaction, ainsi qu'a la nature des opérations éventuellement réalisables avec cette carte sont inscrites en mémoire. Dans l'application concernée cette mémoire est réalisée avec un circuit intégré électronique. Le circuit intégré est inséré sur la carte. Par ailleurs, d'autres informations concernant par exemple le solde d'un compte peuvent y être éventuellement stockées. Pour éviter des falsifications, il convient de rentrer les informations relatives à l'identité, au code secret, et aux opérations réalisables de telle manière qu'elles ne puissent plus ultérieurement être modifiées. Ceci n'est pas le cas du solde du compte qui peut être modifié au fur et à mesure d'achats effectués ou de virements adressés. Les informations dont on veut assurer l'inviolabilité doivent alors être stockées dans des zones particulières de la mémoire et ce sont les accès à ces zones qu'il convient de neutraliser une fois que les informations utiles y ont été inscrites.

Dans l'état actuel de la technique les zones à protéger sont des zones mémoire de circuits intégrés. Les circuits intégrés dont il est question comportent généralement un microprocesseur relié à la mémoire. L'introduction des informations dans la partie de la mémoire qui sera à protéger est obtenue au moyen d'un jeu de connexions donnant un accès direct à cette partie. On applique aux bornes du circuit intégré auquel sont reliées ces connexions des séries d'impulsions électriques propres à introduire les informations utiles dans la zone concernée de la mémoire. Pour empêcher un accès ultérieur à cette zone il a été imaginé de réaliser dans les connexions une partie fusible en série. Lorsque les informations ont été introduites dans la mémoire on fait passer un courant fort dans la connexion, le fusible chauffe et fond découplant ainsi simplement le circuit intégré de ses bornes d'accès. Une telle application est, par exemple, décrite dans la demande de brevet français FR-A-2 503 424.

Le passage d'un courant fort dans la partie fusible ne peut bien entendu pas se faire en injectant ce courant dans la mémoire: il risquerait de détériorer cette mémoire. Lors de l'opération de claquage du fusible on injecte le courant par une première borne reliée à une extrémité de ce fusible et on dérive ce courant vers une deuxième borne par une dérivation raccordée à l'autre extrémité du fusible. Cette autre extrémité du fusible est celle qui donne l'accès proprement dit à la mémoire. Mais si l'accès à la mémoire par la première borne n'est plus exploitable, il n'en est pas de même de l'accès à la mémoire par la deuxième borne raccordée à la dérivation. Ce qui fait qu'en définitive on n'a pas progressé dans le problème puisqu'un opérateur extérieur peut quand même accéder à la zone à protéger de la mémoire en passant par la deuxième borne.

L'invention a pour objet de remédier aux inconvénients cités en proposant un dispositif de neutralisation d'accès comportant une partie fusible dans lequel une des extrémités de cette partie fusible est la borne normale d'accès à la mémoire avant claquage du fusible. L'autre extrémité de cette partie fusible est agencée pour que, en utilisation normale du circuit intégré, sa polarité, qui est justement propice à l'introduction des informations dans la zone à protéger de la mémoire, soit inverse de sa polarité pendant l'opération de claquage.

L'invention concerne un dispositif de neutralisation de l'accès à une zone à protéger d'un circuit intégré, ledit circuit intégré étant réalisé sur un substrat semiconducteur d'un premier type de conductivité donnée, du type comportant une partie fusible, intégrée dans le circuit et placée en série entre une borne de cet accès et la zone à protéger, caractérisé en ce que l'extrémité de la partie fusible la plus proche de la zone est reliée directement à une couche d'un deuxième type de conductivité donnée formant avec le substrat une jonction qui est polarisée en inverse lors de l'utilisation normale dudit circuit, la couche d'un deuxième type de conductivité pénétrant à l'intérieur de la zone à protéger.

L'invention sera mieux comprise à la lecture de la description qui suit et à l'examen des figures qui l'accompagnent. Cette description est donnée à titre indicatif et nullement limitatif de l'invention. Sur les figures les mêmes repères désignent les mêmes éléments. Elles représentent:

– Figure 1, une vue en coupe d'un dispositif de neutralisation conforme à l'invention;

– Figure 2, une vue de dessus d'une coupe effectuée selon le plan AA de la figure 1.

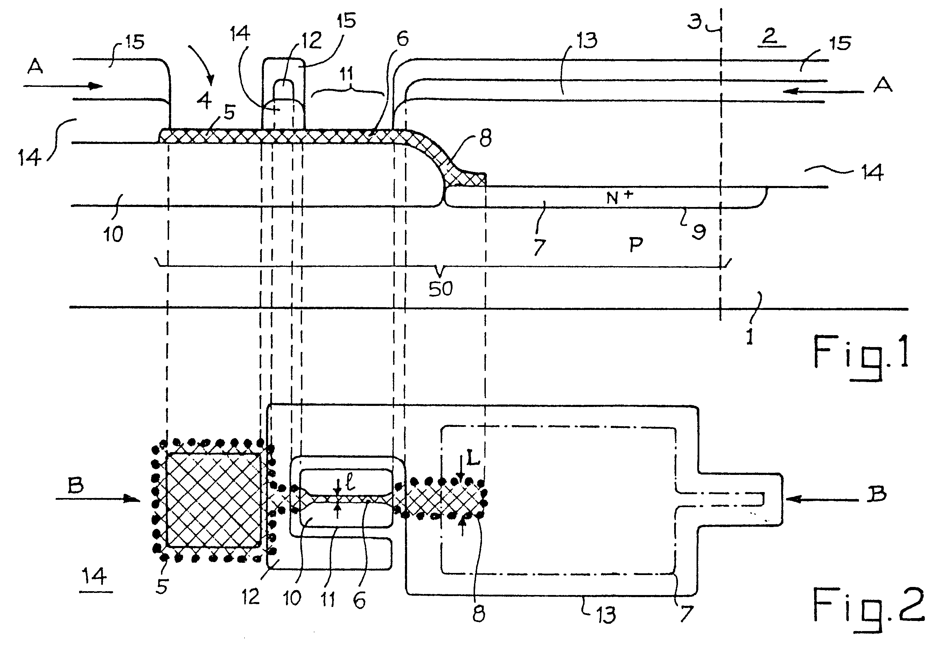

Les deux figures représentent les différentes couches d'un circuit intégré. La figure 1 en coupe est obtenue selon le plan BB de la figure 2.

Ces deux figures représentent un accès à une zone à protéger d'un circuit intégré. Le circuit intégré est réalisé sur un substrat semiconducteur 1 en un premier type de conductivité donné. Dans un exemple ce substrat est en silicium dopé P. La zone à protéger est une zone 2 se trouvant par exemple à droite d'une ligne arbitraire 3 de délimitation de zone. Comme il a été dit plus haut, la zone 2 peut comporter des circuits mémoires intégrés dans le même substrat 1. Elle peut aussi comporter toute autre sorte de circuit. Quels que soient les circuits électroniques réalisés d'une manière intégrée dans la zone 2, ce que l'invention cherche à faire c'est de neutraliser l'accès 4 à cette zone 2. L'accès 4 comporte essentiellement une borne 5 d'une connexion 50. Dans cette connexion la borne 5 est reliée à une partie fusible 6 qui se continue par une couche conductrice 7 qui elle-même pénètre à l'intérieur de la zone 2. Ce qui caractérise l'invention c'est que l'extrémité 8 de la partie fusible, celle qui est la plus proche de la zone à protéger, est reliée directement à la couche 7 qui est en un deuxième type de conductivité donnée: ici elle est dopée N+. Ce qui est remarquable c'est que la couche 7 forme avec le substrat 1 une jonction qui n'est conductrice que dans un sens. Dans l'invention on s'arrange pour que cette jonction soit conductrice dans un sens qui est favorable au claquage du fusible 6 mais qui est antagoniste de la polarisation normale d'utilisation du circuit intégré.

Dans l'exemple représenté sur les figures le circuit intégré est réalisé en technologie N MOS. En utilisation normale le substrat, qui est de type P, est relié à la masse (c'est-à-dire à zéro volt) alors que d'autres parties du circuit sont polarisées à +VCC. Ceci signifie que le potentiel de polarisation du substrat est inférieur ou égal aux autres potentiels de polarisation du circuit. Or, la jonction 9, séparant le substrat 1 de la couche 7, n'est conductrice que dans le sens substrat 1 vers la couche 7. Ceci signifie qu'elle n'est conductrice que quand le substrat se trouve à un potentiel plus élevé que la couche 7 et donc à un potentiel plus élevé que celui qui est appliqué sur la borne 5. Aussi lorsque la mémoire est programmée, des impulsions électriques variant entre +VCC et 0 volts sont transmises par la couche 7 à la zone 2. Pendant cette phase la jonction 9 est bloquée; la couche 7 est isolée du substrat 1 et les impulsions passent correctement. Pour faire claquer le fusible, si le substrat continue à être maintenu à la masse, il suffit d'alimenter la borne 5 pendant une durée suffisante avec un potentiel négatif. Dans un exemple ce potentiel négatif vaut −12 volts. Dans ce cas la jonction se débloque et le courant va à la borne 5 en fondant le fusible 6.

Une fois que cette opération est réalisée on constate que la couche 7 en relation de conduction avec la zone 2 à protéger ne peut plus être alimentée. En effet le circuit étant alimenté, selon sa polarité normale, entre zéro volt et +VCC l'introduction d'impulsions électriques dans la couche 7 par l'intermédiaire du substrat 1 n'est pas possible. Si l'on soumet cependant ce substrat à des impulsions électriques, premièrement le fonctionnement du circuit intégré sera complètement désorganisé puisque le substrat est commun à tout le circuit intégré. Il n'y a alors aucune chance d'obtenir un effet attendu de programmation de la mémoire. De plus dans le cas où ces impulsions électriques sont négatives, par exemple −VCC, la jonction 9 se bloque: les impulsions ne passent pas. Si les impulsions appliquées sont des impulsions positives pour qu'elles passent à travers la jonction 9 il faut que le potentiel appliqué sur le substrat 1 soit supérieur à +VCC. Ceci est aussi contraire au bon fonctionnement du circuit.

Sur la figure 1 dans l'exemple on remarque que la borne d'accès 5 et la partie fusible 6 sont déposées au-dessus d'une couche 10 isolante obtenue par oxydation locale du substrat 1 à cet endroit. La couche d'isolation 10 peut être remplacée par une couche de nitrure de silicium ($Si_3, N_4$) obtenue par croissance. La diffusion N+ de la couche 7 est une diffusion qui est réalisée par exemple en même temps qu'une diffusion source et drain d'un transistor normal d'un circuit qui serait contenu dans la zone 2 du circuit intégré. En conséquence cette diffusion de couche 7 ne nécessite pas d'étape supplémentaire dans le procédé de fabrication du circuit intégré. La partie de la connexion 50 qui relie la borne d'accès 5 à la couche 7 est réalisée en silicium polycristallin dont l'épaisseur visible sur la figure 1 est d'environ 0,5 microns. A l'endroit du fusible 6 la largeur 1 de ce silicium polycristallin est dans un exemple de 2,5 microns. Pour le reste, sauf à l'endroit de la borne 5 la largeur L du silicium polycristallin vaut environ 20 microns. Ce silicium polycristallin est déposé d'une manière classique une fois que les couches 10 et 7 ont été réalisée. Il peut même être dopé N+ pour améliorer son contact avec la couche 7. Ce dopage peut diffuser sans risque dans cette couche 7.

Sur la figure 2, les contours du silicium polycristallin sont marqués en pointillés aux endroits où il est recouvert par d'autres couches. Ce qu'il y a de remarquable dans l'invention c'est que pour améliorer la fusion du fusible celui-ci est maintenu à l'air libre à l'endroit où sa rupture est attendue. La partie à l'air libre est cotée 11. Pour éviter qu'après l'opération de claquage on puisse être tenté de venir connecter une électrode sur un moignon du fusible qui continuerait à apparaître dans cette partie libre à l'air libre 11, cette partie est encerclée par une ceinture de métal 12. Ce métal peut être de l'aluminium. Cette ceinture de métal 12 est raccordée à une plaque métallique 13. Cet ensemble ceinture-plaque est connecté par ailleurs à un potentiel constant (non représenté). Une fois que le fusible a fondu la couche 7 est naturellement portée, par les circuits dans la zone 2, à une potentiel dit de repos. Le potentiel constant auquel est raccordé l'ensemble ceinture plaque est opposé à ce potentiel de repos. En particulier la plaque 13 peut être reliée à la masse. En conséquence toute tentative d'un opérateur, nécessairement malhabile du fait de l'exiguïté de la partie à l'air libre 11, comporte le risque de toucher la ceinture 12 en même temps que le moignon du fusible 6. Ceci empêche la transmission d'informations jusque dans la zone 2 dont on veut interdire l'accès.

Il existe des risques de pollution du circuit intégré du fait de la présence de la partie 11 à l'air libre. Ils sont compensés par la réalisation d'une couche diffusée 7 large. Cette largeur est par ailleurs favorable au passage d'un courant fort dans la jonction 9. Mais cette couche 7 devient alors de grandeur appréciable. Pour éviter que cette couche 7 ne puisse servir elle-même de connexion à la zone 2 à protéger, elle est recouverte par la plaque 13. Dans ces conditions la perforation par une électrode, du circuit intégré à l'endroit de cette couche 7 ne pourrait pas servir à atteindre cette couche sans toucher également la plaque 13. Ceci est apparent sur la figure 2 où les contours de la zone diffusée 7 sont en traits-points à l'intérieur du contour de la plaque 13. Comme les dispositions de la plaque métallique 13 et de la ceinture 12 ne sont pas réalisables directement sur le silicium polycristallin et sur la couche 7 il convient de les en séparer par une couche d'isolation. Cette couche d'isolation cotée 14, qui apparaît partout sur la figure 2 sauf dans la partie à l'air libre 11 et au droit de la borne 5 est réalisée en déposant un oxyde par décomposition chimique en phase gazeuse à basse pression (LPCVD).

Pour la finition du circuit intégré celui-ci est généralement recouvert d'une couche diélectrique 15. Cette couche 15 est appliquée sur la surface générale. L'ouverture à l'air libre de la partie 11 est alors obtenue par une attaque par plasma sur ce diélectrique. Cette attaque par plasma est préférée à une attaque humide. Dans une attaque humide (chimique) lu fusible risquerait d'être attaqué. Si le silicium polycristallin du fusible était attaqué son épaisseur se réduirait. La résistance du fusible augmenterait et le courant dans le fusible au moment du claquage diminuerait: le fusible ne fonderait plus. C'est pour cette raison que la couche 14 d'isolation qui est également appliquée partout, et donc en particulier au-dessus de la partie 11 et de la borne 5, est conservée au-dessus de cette partie 11 après la gravure des métallisations (en particulier la métallisation sur la borne d'accès 5). Cette couche 14 est même conservée au-dessus de la partie 11 après le nettoyage qui suit directement la gravure des métallisations. L'ouverture à l'air libre de la partie 11 est faite en dernier: c'est une ouverture verticale par plasma de la couche 15 et de la couche 14. C'est la seule opération spéciale qui dans le procédé de fabrication du circuit intégré de l'invention se différencie d'un procédé de fabrication classique de circuit intégré.

## Revendications

1. Dispositif de neutralisation de l'accès (4) à une zone (2) à protéger d'un circuit intégré, ledit circuit intégré étant réalisé sur un substrat (1) semiconducteur d'un premier type de conductivité donnée (P), du type comportant une partie fusible (6), intégrée dans le circuit et placée en série entre une borne (5) de cet accès et la zone (2) à protéger, caractérisé en ce que l'extrémité (8) de la partie fusible la plus proche de la zone est reliée directement à une couche (7) d'un deuxième type de conductivité donné (N+) formant avec le substrat une jonction (9) qui est polarisée en inverse lors de l'utilisation normale dudit circuit la couche (7) d'un deuxième type de conductivité pénétrant à l'intérieur de la zone (2) à protéger.

2. Dispositif selon la revendication 1 caractérisé en ce que la partie fusible débouche (11) à l'air libre pour améliorer sa fusion.

3. Dispositif selon l'une quelconque des revendications 1 ou 2 caractérisé en ce que la partie fusible est surmontée d'une partie métallique (12) qui l'encercle et qui repose au-dessus d'elle par l'intermédiaire d'une couche isolante (14), ladite partie métallique étant reliée à un potentiel constant du circuit, opposé à un potentiel de repos de la couche en un deuxième type de conductivité.

4. Dispositif selon la revendication 3 caractérisé en ce que la partie métallique (12) est par ailleurs reliée à une autre partie métallique (13) qui surplombe la jonction.

5. Dispositif selon l'une quelconque des revendications 1 à 4 caractérisé en ce que la partie fusible (6) est réalisée en silicium polycristallin.

6. Dispositif selon la revendication 5 caractérisé en ce que la partie fusible (6) mesure 2,5 microns de large et 0,5 microns d'épaisseur.

7. Dispositif selon l'une quelconque des revendications 1 à 6 caractérisé en ce que la partie fusible (6) repose sur une couche (10) d'oxyde épais formée au-dessus du substrat.

8. Dispositif selon l'une quelconque des revendications 1 à 6 caractérisé en ce que la partie fusible (6) repose sur une couche (10) de nitrure de silicium.

9. Dispositif selon l'une quelconque des revendications 1 à 8 caractérisé en ce que le circuit intégré est en technologie MOS.

10. Dispositif selon l'une quelconque des revendications 1 à 9, caractérisé en ce que le circuit intégré est réalisé en technologie N MOS.

11. Dispositif selon l'une quelconque des revendications 2 à 10 caractérisé en ce que le circuit intégré est recouvert d'une couche diélectrique (15) en dehors des parties laissées à l'air libre.

## Patentansprüche

1. Vorrichtung zur Neutralisierung des Zugangs (4) zu einer zu schützenden Zone (2) einer integrierten Schaltung, wobei die genannte integrierte Schaltung auf einem Halbleitersubstrat (1) eines ersten gegebenen Leitfähigkeitstyps (P) gebildet ist, vom Typ mit einem Sicherungsteil (6), der in die Schaltung integriert und zwischen einem Anschluss (5) dieses Zugangs und der zu schützenden Zone (2) in Reihe geschaltet ist, dadurch gekennzeichnet, dass das Ende (8) des Sicherungsteils, welches der Zone am nächsten liegt, unmittelbar mit einer Schicht (7) eines zweiten vorgegebenen Leitfähigkeitstyps (N+) verbunden ist, wobei die Schicht mit dem Substrat einen bei der normalen Verwendung der Schaltung in Sperrichtung gepolten Übergang (9) bildet und wobei die Schicht (7) des zweiten Leitfähigkeitstyps in das Innere der.zu schützenden Zone (2) eindringt.

2. Vorrichtung nach Anspruch 1, dadurch gekennzeichnet, dass der Sicherungsteil in die freie Luft (11) ausmündet, um sein Durchschmelzen zu unterstützen.

3. Vorrichtung nach einem der Ansprüche 1 und 2, dadurch gekennzeichnet, dass der Sicherungsteil von einem Metallteil (12) überlagert ist, der ihn umgibt und über ihm über eine Isolierschicht (14) liegt, wobei der genannte Metallteil mit einem konstanten Potential der Schaltung verbunden ist, das einem Ruhepotential der Schicht des zweiten Leitfähigkeitstyps entgegengesetzt ist.

4. Vorrichtung nach Anspruch 3, dadurch gekennzeichnet, dass der Metallteil (12) ferner mit einem weiteren Metallteil (13), der über dem Übergang liegt, verbunden ist.

5. Vorrichtung nach einem der Ansprüche 1 bis 4, dadurch gekennzeichnet, dass der Sicherungsteil (6) aus polykristallinem Silizium besteht.

6. Vorrichtung nach Anspruch 5, dadurch gekennzeichnet, dass der Sicherungsteil (6) 2,5 Mikron breit und 0,5 Mikron dick ist.

7. Vorrichtung nach einem der Ansprüche 1 bis 6, dadurch gekennzeichnet, dass der Sicherungsteil (6) auf einer Schicht (10) aus einem dicken Oxid ruht, die über dem Substrat gebildet ist.

8. Vorrichtung nach einem der Ansprüche 1 bis 6, dadurch gekennzeichnet, dass der Sicherungsteil (6) auf einer Schicht (10) aus Siliziumnitrid ruht.

9. Vorrichtung nach einem der Ansprüche 1 bis 8, dadurch gekennzeichnet, dass die integrierte Schaltung in MOS-Technologie ausgebildet ist.

10. Vorrichtung nach einem der Ansprüche 1 bis 9, dadurch gekennzeichnet, dass die integrierte Schaltung in N-MOS-Technologie ausgebildet ist.

11. Vorrichtung nach einem der Ansprüche 2 bis 10, dadurch gekennzeichnet, dass die integrierte Schaltung von einer dielektrischen Schicht (15) ausserhalb der Teile, die an der freien Luft liegen, überzogen ist.

## Claims

1. A device for neutralization of access (4) to a zone (2) to be protected of an integrated circuit, said integrated circuit being produced on a semiconductor substrate (1) of a first given type (P) of conductivity, of the type comprising a fusible part (6), integrated in the circuit and placed in series between a terminal of this access and the zone (2) to be protected, characterized in that the extremity (8) of the fusible part nearest to the zone is directly connected with a layer (7) of a second given type (N+) of conductivity forming, with the substrate, a junction (9) which is inversely polarized at the time of normal use of the circuit, the layer (7) of a second type of conductivity penetrating into the interior of the zone (2) to be protected.

2. The device as claimed in claim 1, characterized in that the fusible part opens (11) into the open air in order to improve the fusion thereof.

3. The device as claimed in claim 1 or claim 2, characterized in that the fusible part is surmounted by a metallic part (12) which encircles it and rests on top of it with an insulating layer (14) therebetween as an intermediary, the said metallic part being connected with a constant potential of the circuit, opposite to a resting potential of the layer made with the second type of conductivity.

4. The device as claimed in claim 3, characterized in that the metallic part (12) also connected with another metallic part (13) which overhangs the junction.

5. The device as claimed in any one of the claims 1 through 4, characterized in that the fusible part (6) is made of polycrystalline silicon.

6. The device as claimed in claim 5, characterized in that the fusible part (6) is 2.5 microns in width and 0.5 microns in thickness.

7. The device as claimed in any one of the claims 1 through 6, characterized in that the fusible part (6) rests on a layer (10) of thick oxide formed above the substrate.

8. The device as claimed in any one of the claims 1 through 6, characterized in that the fusible part (6) rests ona a layer (10) of silicon nitride.

9. The device as claimed in any one of the claims 1 through 8, characterized in that the integrated circuit is an MOS circuit.

10. The device as claimed in any one of the claims 1 through 9, characterized in that the integrated circuit is an N-MOS circuit.

11. The device as claimed in any one of the claims 2 through 10, characterized in that the integrated circuit is covered with a dielectric layer (15) outside the parts exposed to the open air.

Fig.1

Fig.2